# EUROPÄISCHE PATENTSCHRIFT

(11) **EP 2 786 403 B1**
(45) Veröffentlichungstag und Bekanntmachung des Hinweises auf die Patenterteilung: **07.11.2018**
(21) Anmeldenummer: 12769617.7
(22) Anmeldetag: 06.09.2012
(51) Int. Cl.: H01L 21/263, H01L 29/868, H01L 21/324, H01L 29/06, H01L 29/36, H01L 21/329

(54) **VERFAHREN ZUR DOTIERUNG EINES HALBLEITERKÖRPERS UND HALBLEITERBAUELEMENT**
METHOD FOR DOPING A SEMICONDUCTOR BODY, AND SEMICONDUCTOR COMPONENT
PROCÉDÉ DE DOPAGE D'UN CORPS SEMI-CONDUCTEUR ET COMPOSANT SEMI-CONDUCTEUR

(30) Priorität: 30.11.2011 DE 102011087473
(43) Veröffentlichungstag der Anmeldung: 08.10.2014
(73) Patentinhaber: Infineon Technologies Bipolar GmbH & Co. KG, 59581 Warstein (DE)
(72) Erfinder: BARTHELMESS, Reiner, 59494 Soest (DE); SCHULZE, Hans-Joachim, 82024 Taufkirchen (DE); KELLNER-WERDEHAUSEN, Uwe, 91359 Leutenbach (DE)
(74) Vertreter: Lohmanns, Bernard
(86) Internationale Anmeldenummer: PCT/EP2012/067440
(87) Internationale Veröffentlichungsnummer: WO 2013/079234

(56) Entgegenhaltungen:
- DE-A1-102007 001 108
- DE-A1-102007 033 873
- DE-B3-102008 049 664
- JP-A- S6 066 477
- US-A1- 2006 286 753

## Beschreibung

Die vorliegende Erfindung betrifft ein Verfahren zur Dotierung eines Halbleiterkörpers mit einer gezielten, lateralen Variation der Dotierungskonzentration im Halbleiterkörper sowie ein auf diese Weise hergestelltes Halbleiterbauelement.

Es ist an sich bekannt, dass die Randgestaltung von Halbleiterbauelementen einen erheblichen Einfluss auf die erzielbare Sperrspannung des Bauelements hat. Allgemein lassen sich die Randstrukturen von Halbleiterbauelementen in zwei Hauptgruppen unterteilen: Randstrukturen, bei denen durch eine Randabschrägung ein Winkel eingestellt wird, unter dem beispielsweise ein pn-Übergang die Halbleiteroberfläche schneidet, und Randstrukturen mit ebener Halbleiteroberfläche, die als planare Randstrukturen bezeichnet werden.

Die Randabschrägung im Randbereich des Halbleiterbauelements kann beispielsweise mechanisch durch Schleifen oder Läppen oder auch auf chemischem Wege durch gezieltes Ätzen hergestellt werden. Der Steigungswinkel der Randabschrägung wird allgemein in Bezug auf einen Übergang von einer höher dotierten auf eine niedriger dotierte Halbleiterzone definiert, wobei von einem positiven Winkel gesprochen wird, wenn der Durchmesser des Halbleiterkörpers in Richtung von der höher dotierten zur niedriger dotierten Halbleiterzone abnimmt, andernfalls von einem negativen Winkel.

Zur Vermeidung überhöhter elektrischer Feldstärken im Randbereich von Halbleiterbauelementen, insbesondere pin-Dioden, mit einer Randabschrägung im Randbereich ist es bisher üblich, die den n-Emitter bildende n+-dotierte Zone lokal mit einer Ätzstruktur zu versehen, die eine Kombination aus so genanntem "depletion etch" und einem negativen Winkel ergibt. Der negative Winkel stellt sich bei der für den Ätzschritt üblicherweise verwendeten Schleuderätzung automatisch ein. Nachteilig ist hierbei jedoch, dass die laterale Variation der sich ergebenden n-Dotierung nur schwer und auch nur in gewissen Grenzen steuerbar ist.

Die DE 10 2007 001108 A1 offenbart ein Verfahren zur Dotierung eines Halbleiterkörpers mit einer gezielten lateralen Variation der Dotierungskonzentration gemäß dem Oberbegriff des Anspruchs 1.

Vor diesem Hintergrund hat sich die vorliegende Erfindung die Aufgabe gestellt, ein Verfahren zur Dotierung eines Halbleiterkörpers bereitzustellen, mit dem eine gezielte laterale Variation der Dotierungskonzentration im Halbleiterkörper, insbesondere in einem Randbereich des Halbleiterkörpers, erreichbar ist, um das Auftreten von überhöhten elektrischen Feldstärken in der derart dotierten Halbleiterzone, insbesondere im Randbereich des Halbleiterkörpers, zu vermeiden. Ferner ist es Aufgabe der Erfindung, ein Halbleiterbauelement mit einer solchen dotierten Halbleiterzone zur Verfügung zu stellen.

Diese Aufgabe wird durch ein Verfahren mit den Merkmalen des Anspruchs 1 und durch ein Halbleiterbauelement mit den Merkmalen des Anspruchs 8 gelöst. Weitere, besonders vor- teilhafte Ausgestaltungen der Erfindung offenbaren die Unteransprüche.

Die Beschreibung charakterisiert und spezifiziert die Erfindung insbesondere im Zusammenhang mit den Figuren zusätzlich.

Erfindungsgemäß umfasst ein Verfahren zur Dotierung eines Halbleiterkörpers, insbesondere eines bevorzugt rotationssymmetrischen Halbleiterkörpers, mit einer gezielten lateralen Variation der Dotierungskonzentration im Halbleiterkörper wenigstens die Schritte, den Halbleiterkörper über eine Oberfläche mit Protonen einer vorbestimmten Implantationsenergie ganzflächig zu bestrahlen, wobei Kristalldefekte, insbesondere Leerstellen, in einer bestrahlten Halbleiterzone entstehen und die Protonen bis in einen beabstandet zur Oberfläche angeordneten End-Of-Range-Bereich des Halbleiterkörpers eindringen; wenigstens eine Randabschrägung im Randbereich der Oberfläche des Halbleiterkörpers mit einem vorbestimmten Steigungswinkel herzustellen; und den Halbleiterkörper wenigstens im Bereich der Oberfläche zu tempern, das heißt einem Temperaturprozess zu unterziehen, wobei die Temperatur und die Zeitdauer derart aufeinander abgestimmt sind, dass die Kristalldefekte, insbesondere Leerstellen, aus der Halbleiterzone in Richtung der Oberfläche und die Protonen aus dem End-Of-Range-Bereich in Richtung der Oberfläche diffundieren und dass im End-Of-Range-Bereich und zwischen der Oberfläche und dem End-Of-Range-Bereich eine n-Dotierung der Halbleiterzone mit wasserstoffinduzierten Donatoren entsteht.

Durch die Protonenimplantation werden Protonen in die durchstrahlte Halbleiterzone eingebracht, die bis zu einem beabstandet zu der Oberfläche des Halbleiterkörpers angeordneten, sogenannten End-Of-Range-Bereich der Bestrahlung in den Halbleiterkörper eindringen. Der End-Of-Range-Bereich bezeichnet hierbei die Position im Halbleiterkörper in Bestrahlungsrichtung, an der unmittelbar nach der Implantation die Protonenkonzentration am größten ist, was hierin auch als Dotierungspeak bezeichnet wird. Der Abstand des End-Of-Range-Bereichs zur Oberfläche bzw. Bestrahlungsseite des Halbleiterkörpers ist dabei abhängig von der Implantationsenergie und nimmt mit zunehmender Implantationsenergie zu. Auf dem Weg von der Oberfläche bis in den End-Of-Range-Bereich, in den der Großteil der Protonen vordringt, hinterlassen die Protonen Kristalldefekte, insbesondere Leerstellen. Die Abmessungen der die Kristalldefekte aufweisenden, von Protonen durchstrahlten Halbleiterzone in Bestrahlungsrichtung ausgehend von der Oberfläche des Halbleiterkörpers sind dabei wie der Abstand des End-Of-Range-Bereichs zur Oberfläche ebenfalls von der Implantationsenergie abhängig.

An die Protonenbestrahlung schließt sich die Herstellung wenigstens einer Randabschrägung in einem Randbereich der Oberfläche des Halbleiterkörpers an. Bevorzugt wird die Randabschrägung mit einem flachen Gradienten bzw. Steigungswinkel zwischen 1° und 5°, besonders bevorzugt zwischen 2° bis 4° hergestellt. Eine solche Randabschrägung kann beispielsweise durch eine herkömmliche Schleuderätzung durchgeführt werden, bei welcher der Halbleiterkörper rotierend lokal einem Ätzstrahl ausgesetzt wird. Ferner kann die Randabschrägung zur Erzielung einer besonders hohen Genauigkeit und sehr guten Reproduzierbarkeit ebenso mit einem Verfahren zur Herstellung einer Randstruktur, das in der anmeldereigenen, deutschen Patentanmeldung DE 10 2010 017 751 A1 beschrieben ist, durchgeführt werden.

An die Protonenbestrahlung schließt sich ein Temperprozess an, bei dem der Halbleiterkörper wenigstens im Bereich der mit Protonen bestrahlten Halbleiterzone auf Temperaturen zwischen 250 °C und 550 °C, bevorzugt zwischen 400 °C und 530 °C und besonders bevorzugt zwischen 450 °C und 500 °C aufgeheizt wird. Die Zeitdauer des Temperns liegt allgemein zwischen 1 Stunde und 50 Stunden, bevorzugt zwischen 2 Stunden und 20 Stunden und besonders bevorzugt zwischen 4,5 Stunden und 10 Stunden, wobei die Temperatur während des Temperns konstant sein oder auch innerhalb der zuvor genannten Grenzen variiert werden kann. Bei einer Verlängerung der Temperdauer kann die Temperatur entsprechend abgesenkt werden.

Während des Temperprozesses entstehen durch die Komplexbildung aus den durch die Protonenimplantation erzeugten Kristalldefekten insbesondere Leerstellen und den eingebrachten Protonen wasserstoffinduzierte Donatoren, das heißt eine n-Dotierung der Halbleiterzone. Wie bereits erläutert, werden die Protonen durch die Protonenimplantation hauptsächlich in den End-Of-Range-Bereich der Bestrahlung eingebracht. Der End-Of-Range-Bereich bildet somit das "Ende" des durch die Protonen implantation bestrahlten Gebietes in Bestrahlungsrichtung des Halbleiterkörpers. Die Bildung wasserstoffinduzierter Donatoren setzt das Vorhandensein von geeigneten Kristalldefekten insbesondere Leerstellen, und das Vorhandensein von Protonen voraus.

Bei geeigneter Wahl des Abstands des End-Of-Range-Bereichs zu der mit einer Randabschrägung versehenen Oberfläche des Halbleiterkörpers sowie der Temperatur und der Zeitdauer des Temperprozesses diffundieren in dem mit der Randabschrägung versehenen Randbereich sowohl die durch die Bestrahlung erzeugten Kristalldefekte, insbesondere Leerstellen, als auch die implantierten Protonen bzw. Wasserstoffatome umso stärker aus der Halbleiteroberfläche aus, je dichter der End-Of-Range-Bereich an der Halbleiteroberfläche liegt, wodurch sich automatisch mit abnehmendem Abstand des End-Cf-Range-Bereichs zur Halbleiteroberfläche eine abnehmende Dotierung ergibt. Insbesondere resultiert somit aufgrund der vorhandenen Strukturierung der Halbleiteroberfläche, das heißt der Randabschrägung, im Randbereich mit zunehmendem Radius eine graduelle Abnahme der durch die Protonenbestrahlung erzeugten n-Dotierung der Halbleiterzone.

Bei gleicher Dauer des Temperprozesses gilt, dass der Anteil der aus der bestrahlten Halbleiterzone zur Oberfläche des Halbleiterkörpers diffundierenden Kristalldefekte, insbesondere Leerstellen, sowie der Anteil der aus dem End-Cf-Range-Bereich zur Oberfläche des Halbleiterkörpers diffundierenden Protonen umso größer ist, je höher die Temperatur während des Temperprozesses gewählt ist. Bei gegebener Temperatur während des Temperprozesses ist der Anteil der aus der bestrahlten Halbleiterzone zur Oberfläche des Halbleiterkörpers diffundierenden Kristalldefekte sowie der Anteil der aus dem End-Of-Range-Bereich zur Oberfläche des Halbleiterkörpers diffundierenden Protonen umso größer, je länger die Dauer des Temperprozesses ist.

Die in die Tiefe des Halbleiterkörpers, das heißt in die entgegengesetzte Richtung diffundierenden Protonen führen in diesem Bereich nicht zur Bildung von Donatoren, da dort keine implantationsinduzierten Kristalldefekte, insbesondere Leerstellen, die zur Bildung von Donatoren erforderlich sind, vorhanden sind.

Die zuvor erläuterten Implantations- und Temperaturprozesse zur Herstellung der n-dotierten Halbleiterzone lassen sich mit Verfahrensschritten zur Herstellung von Halbleiterbauelementen in dem Halbleiterkörper kombinieren. Die Prozesse zur Herstellung der mittels Protonenimplantation dotierten Halbleiterzone werden allerdings erst dann ausgeführt, wenn andere Temperaturprozesse, bei denen der Halbleiterkörper auf Temperaturen aufgeheizt wird, die oberhalb der zuvor genannten Temperaturbereiche liegen, abgeschlossen sind. Insbesondere wird das erfindungsgemäße Verfahren erst unmittelbar vor der erwähnten Strukturierung der Halbleiteroberfläche, das heißt dem Herstellen der Randabschrägung bzw. der Randabschrägungen, ausgeführt.

Gemäß des erfindungsgemäßen Verfahrens wird der Halbleiterkörper, der ferner eine Grunddotierung aufweist, mit einer solchen Implantationsdosis der Protonen bestrahlt, dass die Dotierungskonzentration im End-Of-Range-Bereich nach dem Tempern höher ist als die Dotierungskonzentration der Grunddotierung des Halbleiterkörpers. Hierfür geeignete Implantationsdosen der Protonen liegen bevorzugt im Bereich von 10¹³ bis zu einigen 10¹⁴ cm⁻², wobei im Sinne der vorliegenden Erfindung unter "einige" 10¹⁴ cm⁻² der Bereich von etwa 2·10¹⁴ cm⁻² bis etwa 9·10¹⁴ cm⁻² zu verstehen ist. Eine derart hergestellte, wasserstoffinduzierte Donatoren aufweisende Halbleiterzone weist nach dem Tempern eine ausreichende n-Dotierung auf, um eine an ein diese Halbleiterzone aufweisendes Halbleiterbauelement, insbesondere Leistungshalbleiterbauelement, angelegte Sperrspannung aufzunehmen und ferner die Ausbreitung der Raumladungszone bei zunehmender angelegter Sperrspannung effektiv zu bremsen. Insbesondere bewirkt die durch die Protonenbestrahlung erzeugte n-Dotierung der Halbleiterzone in Verbindung mit der bereits erläuterten graduellen Abnahme der Dotierungskonzentration im Randbereich des Halbleiterkörpers mit zunehmendem Radius eine gezielte Verringerung der elektrischen Feldstärke der durch die n-dotierte Halbleiterzone aufgenommenen Sperrspannung im Randbereich und somit zu einer erhöhten Durchbruchsfestigkeit des Randbereiches des Halbleiterkörpers insgesamt.

Eine vorteilhafte Ausgestaltung des erfindungsgemäßen Verfahrens sieht vor, dass der Halbleiterkörper, der ferner eine an die Oberfläche angrenzende zweite Halbleiterzone aufweist, mit einer solchen Implantationsenergie der Protonen bestrahlt wird, dass der End-Of-Range-Bereich bzw. der Dotierungspeak nach dem Tempern bevorzugt zwischen 1 µm und 30 µm, besonders bevorzugt zwischen 1 µm und 10 µm unterhalb der zweiten Halbleiterzone liegt. Dies ermöglicht eine maximale Nutzung des sich an die durch die Protonenbestrahlung und das Tempern n-dotierte Halbleiterzone anschließenden Bereichs des Halbleiterkörpers, der sich von der Oberfläche in die Tiefe des Halbleiterkörpers erstreckt. Dieser Bereich kann zum Beispiel die Driftzone eines MOSFET, die Driftzone bzw. n-Basis eines IGBT oder die Driftzone bzw. n-Basis einer Diode sein.

Gemäß der vorliegenden Erfindung umfasst ein Halbleiterbauelement einen Halbleiterköper mit einer Oberfläche, eine Innenzone mit einer Grunddotierung, eine an die Innenzone angrenzende n-dotierte Halbleiterzone, die einen an die Innenzone angrenzenden , durch Protonenbestrahlung erzeugten End-Of-Range-Bereich aufweist, wobei die Dotierungskonzentration der durch wasserstoffinduzierte Donatoren gebildeten n-Dotierung der Halbleiterzone höher ist als die Dotierungskonzentration der Innenzone, sowie eine Randabschrägung im Randbereich der Oberfläche des Halbleiterkörpers. Erfindungsgemäß nimmt die Dotierungskonzentration der n-dotierten Halbleiterzone im Randbereich des End-Of-Range-Bereichs mit zunehmendem Radius ab. Die die n-Dotierung mit wasserstoffinduzierten Donatoren aufweisende Halbleiterzone eignet sich insbesondere zur Aufnahme einer an das Halbleiterbauelement angelegten Sperrspannung. Insbesondere führt die im Randbereich mit zunehmendem Radius graduelle Abnahme der durch die Protonenbestrahlung erzeugten n-Dotierung der Halbleiterzone zu einer gezielten Verringerung der elektrischen Feldstärke einer an das Halbleiterbauelement angeschlossenen und von diesem aufgenommenen Sperrspannung im Randbereich, wodurch der Randbereich im Fall hoher anliegender Sperrspannungen entlastet wird. Insgesamt lässt sich auf diese Weise eine erhöhte Durchbruchsfestigkeit des Randbereiches des Halbleiterbauelements erzielen.

Weitere vorteilhafte Einzelheiten und Wirkungen der Erfindung sind im Folgenden anhand eines in den Figuren dargestellten Ausführungsbeispiels näher erläutert. Es zeigen:
Fig. 1 eine Seitenquerschnittsansicht einer pin-Leistungsdiode zur Veranschaulichung eines Ausführungsbeispiels des erfindungsgemäßen Verfahrens,
Fig. 2 eine Seitenquerschnittsansicht der pin-Leistungsdiode aus Figur 1 nach Durchführung weiterer Verfahrensschritte, bei denen ein End-Of-Range-Bereich durch Protonenbestrahlung gebildet und zwei Randabschrägungen im Randbereich des Halbleiterkörpers mit unterschiedlichen Steigungswinkeln hergestellt wurden, und
Fig. 3 einen Dotierungskonzentrationsverlauf innerhalb des in Figur 2 dargestellten End-Of-Range-Bereichs in Abhängigkeit vom Radius.

In den unterschiedlichen Figuren sind gleiche Teile stets mit denselben Bezugszeichen versehen, so dass diese in der Regel auch nur einmal beschrieben werden.

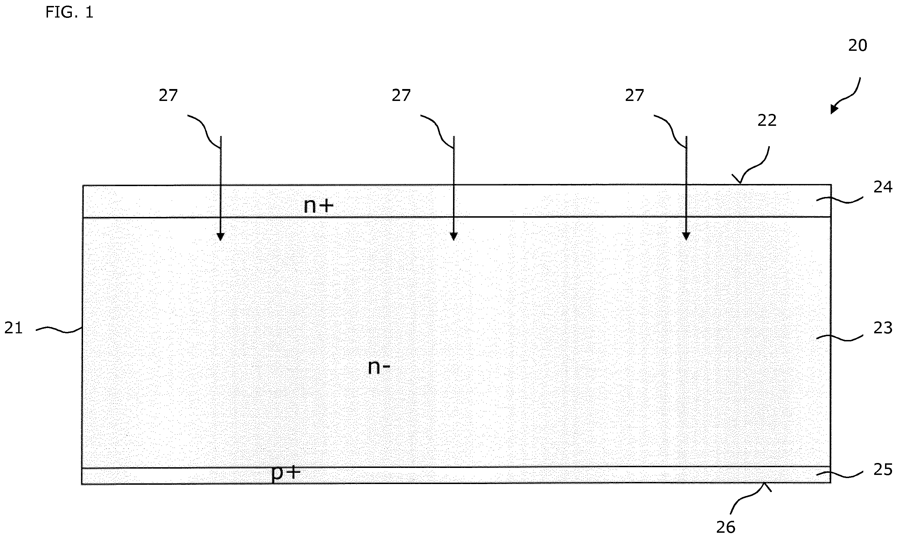

Figur 1 zeigt eine Seitenquerschnittsansicht eines Halbleiterbauelements 20 zur Veranschaulichung eines Ausführungsbeispiels des erfindungsgemäßen Verfahrens, wobei das Halbleiterbauelement 20 als rotationssymmetrische pin-Leistungsdiode ausgebildet ist. Die Diode 20 umfasst einen Halbleiterkörper 21 mit einer Oberfläche 22 und eine Innenzone 23 mit einer n⁻-Grunddotierung. Da das Halbleiterbauelement 20 in dem in Figur 1 dargestellten Ausführungsbeispiel als pin-Diode ausgebildet ist, weist es zusätzlich eine zwischen der Oberfläche 22 und der Innenzone 23 angeordnete zweite, hochdotierte n+-Halbleiterzone 24 sowie eine in vertikaler Richtung unterhalb der Innenzone 23 angeordnete dritte, hochdotierte p⁺-Halbleiterzone 25 auf, die an eine zweite, der Oberfläche 22 gegenüberliegenden Oberfläche 26 des Halbleiterkörpers 21 angrenzt.

Wie in Figur 1 durch entsprechende Pfeile 27 angedeutet ist, wird das Halbleiterbauelement 20 bzw. der Halbleiterkörper 21 in dem dargestellten Verfahrensschritt bevorzugt über die an die Oberfläche 22 angrenzende n⁺-Halbleiterzone 24 ganzflächig mit Protonen bestrahlt.

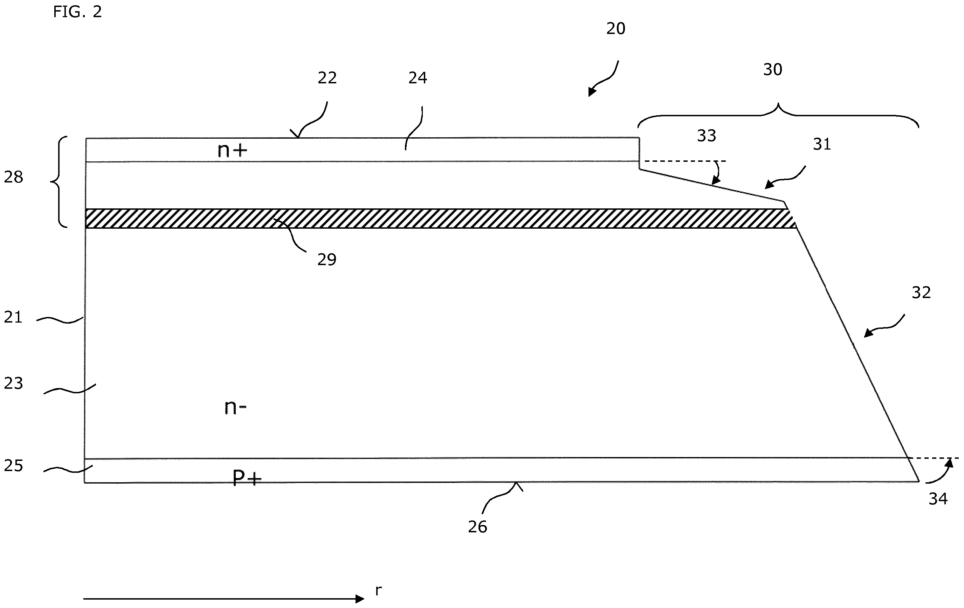

In Figur 2 ist das Halbleiterbauelement 20 bzw. die pin-Leistungsdiode 20 aus Figur 1 nach Durchführung weiterer Schritte des erfindungsgemäßen Verfahrens dargestellt. Insbesondere bewirkt die in Figur 1 dargestellte ganzflächige Protonenbestrahlung 27 des Halbleiterkörpers 21 mit einer bestimmten Implantationsenergie der Protonen, dass Kristalldefekte in einer durchstrahlten Halbleiterzone 28 entstehen und die Protonen bis in einen beabstandet zur Oberfläche 22 angeordneten, so genannten End-Of-Range-Bereich 29 des Halbleiterkörpers 21 eindringen. Wie bereits erläutert, stellt der End-Of-Range-Bereich 29 denjenigen vertikalen Bereich im Halbleiterkörper 21 dar, an der unmittelbar nach der Bestrahlung bzw. Implantation die Protonenkonzentration am größten ist (Dotierungspeak). Somit werden durch die Protonenbestrahlung die Protonen hauptsächlich in den End-Of-Range-Bereich 29 eingebracht und der End-Of-Range-Bereich 29 bildet im Wesentlichen das Ende des durch die Protonenimplantation bestrahlten Gebiets in vertikaler Richtung bzw. Bestrahlungsrichtung des Halbleiterkörpers 21.

Der vertikale Abstand bzw. die Tiefe des End-Of-Range-Bereichs 29 zur Oberfläche 22 wird durch die Implantationsenergie der Protonen, mit denen der Halbleiterkörper 21 bestrahlt wird, festgelegt. Gemäß der Erfindung liegt der End-Of-Range-Bereich 29 bzw. der Dotierungspeak nach dem Tempern bevorzugt zwischen 1 µm und 30 µm, besonders bevorzugt zwischen 1 µm und 10 µm unterhalb der zweiten Halbleiterzone. Dies ermöglicht eine maximale Nutzung der sich an den End-Of-Range-Bereich 29 in vertikaler Richtung nach unten anschließenden Innenzone 23, beispielsweise zur Aufnahme einer an die Diode 20 angelegten Sperrspannung. Ferner wird die Dosis der Protonenbestrahlung erfindungsgemäß derart gewählt, dass bei einer späteren geeigneten Temperung eine n-Dotierung entsteht, die ausreichend hoch ist, um die Ausbreitung der Raumladungszone bei einer an die Diode 20 angelegten, zunehmenden Sperrspannung effektiv zu bremsen. Hierfür geeignete Dosen liegen im Bereich von 10¹³ bis zu einigen 10¹⁴ cm⁻².

Wie der Figur 2 ferner zu entnehmen ist, sind in einem Randbereich 30 der Oberfläche 22 des dargestellten Halbleiterkörpers 21 bzw. der Diode 20 eine erste Randabschrägung 31, die sich im Wesentlichen innerhalb der Halbleiterzone 28 erstreckt, und eine zweite Randabschrägung 32, die sich wenigstens über die Halbleiterzonen 23 und 25 erstreckt, hergestellt
worden. Die Randabschrägungen 31 und 32 weisen jeweils unterschiedliche Steigungswinkel 33 und 34 auf, sie werden vor dem Temperschritt des erfindungsgemäßen Verfahrens an der Oberfläche 22 bzw. 26 des Halbleiterkörpers 21 hergestellt. Hierbei wird die Randabschrägung 32 bevorzugt durch Schleifen, Läppen des Halbleiterkörpers 21 und dergleichen hergestellt, wohingegen die Randabschrägung 31 bevorzugt durch Ätzen, beispielsweise Schleuderätzen, hergestellt wird. Wie der Figur 2 ferner entnommen werden kann, wurde die Halbleiterzone 24 bei dem dargestellten Ausführungsbeispiel bei der Herstellung der Randabschrägung 31 vollständig durchgeätzt. Das heißt, dass sich bei dieser Schleuderätzung eine Struktur ergibt, die sowohl eine Ätzstufe an der Halbleiterzone 24 als auch eine Randabschrägung 31 innerhalb der Halbleiterzone 28 umfasst. Mit anderen Worten umfasst die Randabschrägung 31 an ihrem innen liegenden Startpunkt eine Ätzstufe. Die Randabschrägung 31 kann auch derart ausgebildet sein, dass Reste der Halbleiterzone 24 bestehen bleiben, diese also nicht ganz vollständig durchgeätzt wird.

In Figur 2 ist deutlich zu erkennen, dass die erste Randabschrägung 31 bezogen auf den Übergang von der höher dotierten Halbleiterzone 24 auf die sich darunter anschließende niedriger dotierte Halbleiterzone 28 einen flachen negativen Steigungswinkel 33 aufweist. Bevorzugt beträgt der Winkel 33 zwischen 1° bis 5° und besonders bevorzugt zwischen 2° und 4°. Die zweite Randabschrägung 32 weist bezogen auf den Übergang von der höher dotierten Halbleiterzone 25 auf die sich darüber anschließende niedriger dotierte Innenzone 23 einen positiven Steigungswinkel 34 von bevorzugt 20° bis 80° auf.

Nach der Protonenbestrahlung des Halbleiterkörpers 21 und nach der Herstellung der Randabschrägungen 31 und 32 wird der Halbleiterkörper 21 wenigstens im Bereich der Halbleiterzone 28, das heißt im Bereich der von den Protonen durchstrahlten Halbleiterzone 28, einem Temperprozess unterzogen, wobei die Temperatur und die Zeitdauer derart aufeinander abgestimmt sind, dass die Kristalldefekte aus der Halbleiterzone 28 in Richtung der Oberfläche 22 bzw. der Randabschrägungen 31 und 32 und die Protonen aus dem End-Of-Range-Bereich 29 in Richtung der Oberfläche 22 bzw. der Randabschrägungen 31 und 32 diffundieren. Somit entsteht im End-Of-Range-Bereich 29 sowie zwischen der Oberfläche 22 und dem End-Of-Range-Bereich 29 eine n-Dotierung der Halbleiterzone 28 mit wasserstoffinduzierten Donatoren, wobei die Konzentration in der Halbleiterzone 28 von innen nach außen abnimmt. Insbesondere ist die Dotierungskonzentration wenigstens im End-Of-Range-Bereich 29 und dem Bereich zwischen dem End-Of-Range-Bereich 29 und der Halbeleiterzone 24 nach dem Tempern höher als die Dotierungskonzentration der grunddotierten Innenzone 23, so dass die n-Dotierung des End-Of-Range-Bereichs 29 ausreichend ist, einen Großteil der an die Diode 20 angelegten Sperrspannung aufzunehmen.

Für den Temperprozess des erfindungsgemäßen Verfahrens geeignete Temperaturen betragen zwischen 250 °C und 550 °C, bevorzugt zwischen 400 °C und 530 °C und besonders bevorzugt zwischen 450 °C und 500 °C. Die Zeitdauer des Temperns liegt allgemein zwischen 1 Stunde und 50 Stunden, bevorzugt zwischen 2 Stunden und 20 Stunden und besonders bevorzugt zwischen 4,5 Stunden und 10 Stunden, wobei die Temperatur während des Temperns konstant sein oder auch innerhalb der zuvor genannten Grenzen variiert werden kann. Bei einer Verlängerung der Temperdauer kann die Temperatur entsprechend abgesenkt werden.

Durch den sich im Randbereich 30 des Halbleiterkörpers 21 mit zunehmendem Radius r infolge der Randabschrägung 31 ergebenden abnehmenden Abstand des End-Of-Range-Bereichs 29 zur Oberfläche 22 bzw. zu den Randabschrägungen 31 und 32 sowie der Temperatur und der Zeitdauer während des Temperprozesses diffundieren in dem mit der Randabschrägung 31 versehenen Randbereich 30 sowohl die durch die Bestrahlung erzeugten Kristalldefekte, insbesondere Leerstellen, als auch die implantierten Protonen bzw. Wasserstoffatome umso stärker aus der Halbleiteroberfläche 22 bzw. den Randabschrägungen 31 und 32 aus, je dichter der End-Of-Range-Bereich 29 an der Oberfläche 22 bzw. den Randabschrägungen 31 und 32 liegt. Hierdurch ergibt sich automatisch mit abnehmendem Abstand des End-Of-Range-Bereichs 29 zur Oberfläche 22 bzw. zu den Randabschrägungen 31 und 32 eine abnehmende n-Dotierung innerhalb der Halbleiterzone 28 und insbesondere innerhalb des End-Of-Range-Bereichs 29. Somit resultiert aufgrund der vorhandenen Strukturierung der Halbleiteroberfläche 22, das heißt aufgrund der Randabschrägung 31, im Randbereich 30 mit zunehmendem Radius reine graduelle Abnahme der durch die Protonenbestrahlung erzeugten n-Dotierung der Halbleiterzone 28 bzw. des End-Of-Range- Bereichs 29. Die graduelle Abnahme der n-Dotierung von innen nach außen führt wiederum zu einer gezielten Verringerung der elektrischen Feldstärke im Randbereich 31 einer an die Diode 20 angelegten Sperrspannung, wodurch die Durchbruchsfestigkeit des Randbereiches 30 der Diode 20 erhöht wird.

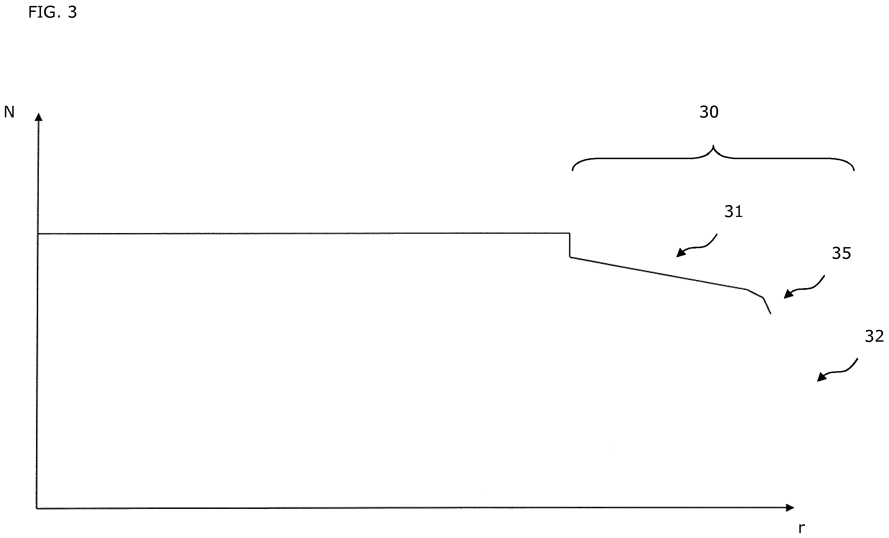

Wie Figur 3, in der ein Dotierungskonzentrationsverlauf innerhalb des in Figur 2 dargestellten End-Of-Range-Bereichs 29 in Abhängigkeit vom Radius r aufgetragen ist, zeigt, beginnt die Abnahme der Dotierungskonzentration im Randbereich 30 der ersten Randabschrägung 31 und verstärkt sich noch aufgrund einer seitlichen Ausdiffusion 35 bei Annäherung an die zweite Randabschrägung 32.

Bei geeigneter Wahl der Implantations- und Temperparameter innerhalb der hierin angegebenen Bereiche kann die mittels des erfindungsgemäßen Verfahrens hergestellte n- Dotierung in der Halbleiterzone 28 bzw. des End-Of-Range-Bereichs 29 auch so eingestellt werden, dass die Durchbruchspannung des Randbereiches 30 über der Durchbruchspannung des inneren Halbleitervolumens liegt, so dass der Randbereich 30 im Fall hoher anliegender Sperrspannungen entlastet wird und der Durchbruch großflächig und homogen, das heißt also auch mit relativ geringen Sperrstromdichten, im zentralen Bereich der Diode 20 erfolgt.

Das erfindungsgemäße Verfahren sowie das erfindungsgemäße Halbleiterbauelement wurden anhand eines in den Figuren dargestellten Ausführungsbeispiels näher erläutert.

Obwohl das erfindungsgemäße Verfahren und das erfindungsgemäße Halbleiterbauelement hierin lediglich anhand einer pin-Diode beschrieben wurden, sind diese selbstverständlich nicht hierauf beschränkt, sondern umfassen ebenso weitere Ausgestaltungen von Halbleiterbauelementen, insbesondere Leistungshalbleiterbauelemente, bei denen die durch die Protonenbestrahlung erzeugte n-dotierte Halbleiterzone zur Aufnahme einer an das im Randbereich mit einer Randabschrägung versehene Halbleiterbauelement angelegten Sperrspannung geeignet ist, wobei die Dotierungskonzentration der Halbleiterzone mit zunehmendem Radius zum Randbereich abnimmt.

In bevorzugter Ausführung wird das erfindungsgemäße Verfahren zur Herstellung von Leistungshalbleiterbauelementen, insbesondere von als pin-Dioden ausgeführte, schnell schaltenden Scheibenzellendioden mit guter Hochspannungsverträglichkeit, verwendet.

### Bezugszeichenliste:

- 20: Halbleiterbauelement pin-Leistungsdiode
- 21: Halbleiterkörper
- 22: Oberfläche
- 23: Innenzone von 20
- 24: Zweite Halbleiterzone
- 25: Dritte Halbleiterzone
- 26: Zweite Oberfläche von 20
- 27: Protonenbestrahlung
- 28: Durchstrahlte Halbleiterzone
- 29: End-Of-Range-Bereich
- 30: Randbereich
- 31: Erste Randabschrägung
- 32: Zweite Randabschrägung
- 33: Negativer Steigungswinkel
- 34: Positiver Steigungswinkel
- 35: Seitliche Ausdiffusion
- r: Radius

## Patentansprüche

1. Verfahren zur Dotierung eines Halbleiterkörpers (21) mit einer gezielten lateralen Variation der Dotierungskonzentration im Halbleiterkörper (21), umfassend wenigstens die Schritte:
- Ganzflächiges Bestrahlen des Halbleiterkörpers (21) über eine Oberfläche (22) mit Protonen einer vorbestimmten Implantationsenergie, wobei Kristalldefekte in einer bestrahlten Halbleiterzone (28) entstehen und die Protonen bis in einen beabstandet zur Oberfläche (22) angeordneten End-Of-Range-Bereich (29) des Halbleiterkörpers (21) eindringen,
- Herstellen wenigstens einer Randabschrägung (31, 32) in einem Randbereich (30) der Oberfläche (22) des Halbleiterkörpers (21) mit einem vorbestimmten Steigungswinkel (33, 34),
- Tempern des Halbleiterkörpers (21) wenigstens im Bereich der Halbleiterzone (28), wobei die Temperatur und die Zeitdauer derart aufeinander abgestimmt sind, dass die Kristalldefekte aus der Halbleiterzone (28) in Richtung der Oberfläche (22) und die Protonen aus dem End-Of-Range-Bereich (29) in Richtung der Oberfläche (22) diffundieren und dass im End-Of-Range-Bereich (29) und zwischen der Oberfläche (22) und dem End-Of-Range-Bereich (29) eine n-Dotierung der Halbleiterzone (28) mit wasserstoffinduzierten Donatoren entsteht;
**dadurch gekennzeichnet, dass**
der Halbleiterkörper (21), der ferner eine n-Grunddotierung aufweist, mit einer solchen Implantationsdosis der Protonen bestrahlt wird, dass die Dotierungskonzentration im End-Of-Range-Bereich (29) nach dem Tempern höher ist als die Dotierungskonzentration der Grunddotierung des Halbleiterkörpers (21).

2. Verfahren nach Anspruch 1, bei dem der Halbleiterkörper (21) mit einer Implantationsdosis der Protonen zwischen 10¹³ cm⁻² und einigen 10¹⁴ cm⁻² bestrahlt wird.

3. Verfahren nach einem der vorhergehenden Ansprüche, bei dem der Halbleiterkörper (21), der ferner eine an die Oberfläche (22) angrenzende zweite Halbleiterzone (24) aufweist, mit einer solchen Implantationsenergie der Protonen bestrahlt wird, dass der End-Of-Range-Bereich (29) bevorzugt zwischen 1 µm und 30 µm, besonders bevorzugt zwischen 1 µm und 10 µm unterhalb der zweiten Halbleiterzone (24) liegt.

4. Verfahren nach einem der vorhergehenden Ansprüche, bei dem die Randabschrägung (31) mit einem flachen Steigungswinkel (33) von bevorzugt zwischen 1° bis 5°, besonders bevorzugt zwischen 2° bis 4° hergestellt wird,

5. Verfahren nach Anspruch 4, bei dem die Randabschrägung (31) mit flachem Steigungswinkel (33) zusätzlich mit einer Ätzstufe hergestellt wird.

6. Verfahren nach einem der vorhergehenden Ansprüche, bei dem im Randbereich (30) der Oberfläche (22) des Halbleiterkörpers (21) zusätzlich zur Randabschrägung (31) eine weitere Randabschrägung (32) mit einem Steigungswinkel (34) von bevorzugt zwischen 20° bis 80° hergestellt wird.

7. Verfahren nach einem der vorhergehenden Ansprüche, bei dem das Tempern bei einer Temperatur bevorzugt zwischen 250 °C und 550 °C, bevorzugt zwischen 400 °C und 530 °C und besonders bevorzugt zwischen 450 °C und 500 °C für eine Zeitdauer zwischen 1 Stunde und 50 Stunden, bevorzugt zwischen 2 Stunden und 20 Stunden und besonders bevorzugt zwischen 4,5 Stunden und 10 Stunden durchgeführt wird.

8. Halbleiterbauelement (20), aufweisend
- einen Halbleiterköper (21) mit einer Oberfläche (22),
- eine Innenzone (23) mit einer n-Grunddotierung,
- eine an die Innenzone (23) angrenzende n-dotierte Halbleiterzone (28), die einen an die Innenzone (23) angrenzenden, durch Protonenbestrahlung erzeugten EndOf-Range-Bereich (29) aufweist, wobei die Dotierungskonzentration der durch wasserstoffinduzierte Donatoren gebildeten n-Dotierung der Halbleiterzone (28) höher ist als die Dotierungskonzentration der Innenzone (23),
- eine Randabschrägung (31) im Randbereich (30) der Oberfläche (22) des Halbleiterkörpers (21), wobei die Dotierungskonzentration im Randbereich (30) des End-Of-Range-Bereichs (29) mit zunehmendem Radius (r) abnimmt.

9. Halbleiterbauelement nach Anspruch 8,
**gekennzeichnet durch**
- eine in der Halbleiterzone (28) angeordnete und an die Oberfläche (22) des Halbleiterkörpers (21) angrenzende zweite Zone (24), deren Dotierungskonzentration höher ist als die Dotierungskonzentration der Halbleiterzone (28),
- eine an die Innenzone (23) und einer der Oberfläche (22) gegenüberliegenden zweiten Oberfläche (26) des Halbleiterkörpers (21) angrenzende dritte Zone (25) eines zum Leitungstyp der zweiten Zone (24) komplementären Leitungstyps, deren Dotierungskonzentration höher ist als die Dotierungskonzentration der Innenzone (23),
- eine zweite Randabschrägung (32), die sich wenigstens entlang der dritten Zone (25) und der Innenzone (23) erstreckt und eine größere Steigung aufweist als die Randabschrägung (31).

10. Halbleiterbauelement nach Anspruch 8 oder 9,
**dadurch gekennzeichnet, dass**
das Halbleiterbauelement als Scheibenzellendiode ausgebildet ist.

## Claims

1. A method for doping a semiconductor body (21) with a targeted lateral variation of the doping concentration in the semiconductor body (21), comprising at least the steps:
full-surface irradiation of the semiconductor body (21) over a surface (22) with protons of a predetermined implantation energy, wherein crystal defects are produced in an irradiated semiconductor zone (28) and the protons penetrate into an end-of-range region (29) of the semiconductor body (21) spaced apart from the surface (22),
- production of at least one edge chamfer (31, 32) in an edge region (30) of the surface (22) of the semiconductor body (21) with a predetermined angle of gradient (33, 34),
- tempering the semiconductor body (21) at least in the region of the semiconductor zone (28), wherein the temperature and the duration of time are adapted to one another in such a way that the crystal defects diffuse from the semiconductor zone (28) in the direction of the surface (22), and the protons from the end-of-range region (29) in the direction of the surface (22), and that an n-type doping of the semiconductor zone (28) with hydrogen-induced donors is created in the end-of-range region (29) and between the surface (22) and the end-of-range region (29),
**characterized in that**
the semiconductor body (21), which further has an n-type basic doping, is irradiated with such an implantation dose of the protons that the doping concentration in the end-of-range region (29) is higher after tempering than the doping concentration of the basic doping of the semiconductor body (21).

2. The method according to claim 1, wherein the semiconductor body (21) is irradiated with an implantation dose of the protons of between 10¹³ cm⁻² and some 10¹⁴ cm⁻².

3. The method according to any one of the preceding claims, wherein the semiconductor body (21), which further has a second semiconductor zone (24) adjacent to the surface (22), is irradiated with such an implantation energy of the protons that the end-of-range region (29) is preferably situated between 1µm and 30µm, particularly preferably between 1µm and 10µm, underneath the second semiconductor zone (24).

4. The method according to any one of the preceding claims, wherein the edge chamfer (31) is produced with a shallow angle of gradient (33) of preferably between 1° to 5°, particularly preferably between 2° to 4°.

5. The method according to claim 4, wherein the edge chamfer (31) with a shallow angle of gradient (33) is additionally produced with an etching step.

6. The method according to any one of the preceding claims, wherein, in the edge region (30) of the surface (22) of the semiconductor body (21), another edge chamfer (32) with an angle of gradient (34) of preferably between 20° to 80° is produced in addition to the edge chamfer (31).

7. The method according to any one of the preceding claims, wherein tempering is carried out at a temperature of preferably between 250°C and 550°C, preferably between 400°C and 530°C, and particularly preferably between 450°C and 500°C for a duration between 1 hour and 50 hours, preferably between 2 hours and 20 hours, and particularly preferably between 4.5 hours and 10 hours.

8. A semiconductor component (20), comprising
- a semiconductor body (21) with a surface (22),
- an inner zone (23) with an n-type basic doping,
- an n-doped semiconductor zone (28), which is adjacent to the inner zone (23) and has an end-of-range region (29) adjacent to the inner zone (23) and produced by proton irradiation, wherein the doping concentration of the n-type doping of the semiconductor zone (28) formed by hydrogen-induced donors is higher than the doping concentration of the inner zone (23),
- an edge chamfer (31) in the edge region (30) of the surface (22) of the semiconductor body (21), wherein the doping concentration in the edge region (30) of the end-of-range region (29) decreases as the radius (r) increases.

9. The semiconductor component according to claim 8,
**characterized by**
- a second zone (24) disposed in the semiconductor zone (28) and adjacent to the surface (22) of the semiconductor body (21), whose doping concentration is higher than the doping concentration of the semiconductor zone (28),
- a third zone (25) of a conduction type complementary to the conduction type of the second zone (24), which is adjacent to the inner zone (23) and to the second surface (26) of the semiconductor body (21) opposite the surface (22) and whose doping concentration is higher than the doping concentration of the inner zone (23),
- a second edge chamfer (32) which extends at least along the third zone (25) and the inner zone (23) and has a larger gradient than the edge chamfer (31).

10. The semiconductor component according to claim 8 or 9,
**characterized in that**
the semiconductor component is configured as a disk cell diode.

## Revendications

1. Procédé de dopage d'un corps semi-conducteur (21) avec une variation latérale ciblée de la concentration du dopage dans le corps semi-conducteur (21), comprenant au moins les étapes suivantes :
- irradiation de toute la surface du corps semi-conducteur (21) sur une surface (22) avec des protons d'une énergie d'implantation prédéterminée, si bien que des défauts du cristal se produisent dans une zone semi-conductrice (28) exposée aux rayons et que les protons pénètrent dans une zone de fin de plage (29) du corps semi-conducteur (21) disposée à distance de la surface (22),
- création d'au moins un chanfreinage en biseau des bords (31, 32) dans une zone périphérique (30) de la surface (22) du corps semi-conducteur (21) avec un angle d'inclinaison prédéterminé (33, 34),
- recuisson du corps semi-conducteur (21) au moins dans la zone semi-conductrice (28), de sorte que la température et la durée soient adaptées l'une à l'autre de telle manière que les défauts du cristal se diffusent de la zone semi-conductrice (28) en direction de la surface (22) et les protons de la zone de fin de plage (29) en direction de la surface (22) et que dans la zone de fin de plage (29) et entre la surface (22) et la zone de fin de plage (29), un dopage n de la zone semi-conductrice (28) se produise avec des donneurs inducteurs d'hydrogène ;
**caractérisé en ce que**
le corps semi-conducteur (21) qui a par ailleurs un dopage de base n est exposé à l'irradiation avec une dose d'implantation des protons telle que la concentration de dopage dans la zone de fin de plage (29) après la recuisson est plus élevée que la concentration de dopage du dopage de base du corps semi-conducteur (21).

2. Procédé selon la revendication 1, dans lequel le corps semi-conducteur (21) est exposé à l'irradiation avec une dose d'implantation des protons comprise entre 10¹³ cm⁻² et certains même à 10¹⁴ cm⁻².

3. Procédé selon l'une des revendications qui précèdent, dans lequel le corps semi-conducteur (21) qui comporte par ailleurs une deuxième zone semi-conductrice (24) limitrophe à la surface (22), est exposé à l'irradiation avec une telle énergie d'implantation des protons que la zone de fin de plage (29) se situe de préférence entre 1 µm et 30 µm, de manière particulièrement préférée entre 1 µm et 10 µm en dessous de la deuxième zone semi-conductrice (24).

4. Procédé selon l'une des revendications qui précèdent, dans lequel le chanfreinage en biseau des bords (31) est réalisé avec un angle d'inclinaison plat (33) mesurant de préférence entre 1° et 5° et de manière particulièrement préférée entre 2° et 4°.

5. Procédé selon la revendication 4, dans lequel le chanfreinage en biseau des bords (31) avec un angle d'inclinaison plat (33) est réalisé en outre avec une étape de décapage.

6. Procédé selon l'une des revendications qui précèdent, dans lequel dans la zone périphérique (30) de la surface (22) du corps semi-conducteur (21), en plus du chanfreinage en biseau des bords (31), un chanfreinage en biseau des bords (32) supplémentaire est réalisé avec un angle d'inclinaison (34) mesurant de préférence entre 20° et 80°.

7. Procédé selon l'une des revendications qui précèdent, dans lequel la recuisson est effectuée à une température comprise de préférence entre 250 °C et 550 °C, de préférence entre 400 °C et 530 °C et de manière particulièrement préférée entre 450 °C et 500 °C, pendant une durée comprise entre 1 heure et 50 heures, de préférence entre 2 heures et 20 heures et de manière particulièrement préférée entre 4,5 heures et 10 heures.

8. Élément semi-conducteur (20), comportant
- un corps semi-conducteur (21) muni d'une surface (22),
- une zone intérieure (23) avec un dopage de base n,
- une zone semi-conductrice à dopage n (28) limitrophe de la zone intérieure (23) qui comporte une zone de fin de plage (29) créée par irradiation de protons et qui est limitrophe de la zone intérieure (23), de sorte que la concentration de dopage du dopage n créé par des donneurs inducteurs d'hydrogène de la zone semi-conductrice (28) soit plus élevée que la concentration de dopage de la zone intérieure (23),
- un chanfreinage en biseau des bords (31) dans la zone périphérique (30) de la surface (22) du corps semi-conducteur (21), dans lequel la concentration de dopage dans la zone périphérique (30) de la zone de fin de plage (29) diminue à mesure que le rayon (r) augmente.

9. Élément semi-conducteur selon la revendication 8,
**caractérisé par :**
- une deuxième zone (24) disposée dans la zone semi-conductrice (28) et limitrophe de la surface (22) du corps semi-conducteur (21), dont la concentration de dopage est plus élevée que la concentration de dopage de la zone semi-conductrice (28),
- une troisième zone (25) placée au niveau de la zone intérieure (23) et limitrophe d'une deuxième surface (26) placée en face de la surface (22) du corps semi-conducteur (21), ladite troisième zone étant d'un type conducteur complémentaire du type conducteur de la deuxième zone (24), dont la concentration de dopage est plus élevée que la concentration de dopage de la zone intérieure (23),
- un deuxième chanfreinage en biseau des bords (32) qui s'étend au moins le long de la troisième zone (25) et de la zone intérieure (23) et qui présente une inclinaison plus grande que le chanfreinage en biseau des bords (31).

10. Élément semi-conducteur selon la revendication 8 ou 9,
**caractérisé en ce que**
l'élément semi-conducteur est conçu sous forme de diode à cellules circulaires.
